# FASCICULE DE BREVET EUROPEEN

(11) **EP 3 467 867 B1**
(45) Date de publication et mention de la délivrance du brevet: **15.12.2021**
(21) Numéro de dépôt: 18196093.1
(22) Date de dépôt: 21.09.2018
(51) Int. Cl.: H01L 21/02, H01L 29/778, H01L 29/66, H01L 21/20, H01L 29/10, H01L 29/20, H01L 29/207, H01L 29/36

(54) **PROCEDE DE FABRICATION D'UN COMPOSANT ELECTRONIQUE A HETEROJONCTION MUNI D'UNE COUCHE BARRIERE ENTERREE**
HERSTELLUNGSVERFAHREN EINER ELEKTRONISCHEN KOMPONENTE MIT HETEROÜBERGANG, DIE MIT EINER VERGRABENEN BARRIERESCHICHT AUSGESTATTET IST
METHOD FOR MANUFACTURING AN ELECTRONIC COMPONENT HAVING A HETEROJUNCTION EQUIPPED WITH A BURIED BARRIER LAYER

(30) Priorité: 03.10.2017 FR 1759218
(43) Date de publication de la demande: 10.04.2019
(73) Titulaire: Commissariat à l'Énergie Atomique et aux Énergies Alternatives, 75015 Paris (FR)
(72) Inventeur: CHARLES, Matthew, 38000 Grenoble (FR)
(74) Mandataire: INNOV-GROUP

(56) Documents cités:
- WO-A1-2009/148930
- US-B1- 7 449 404
- HUILI XING ET AL: "Memory Effect and Redistribution of Mg into Sequentially Regrown GaN Layer by Metalorganic Chemical Vapor Deposition", JAPANESE JOURNAL OF APPLIED PHYSICS, vol. 42, no. Part 1, No. 1, 15 janvier 2003 (2003-01-15), pages 50-53, XP055477267, JP ISSN: 0021-4922, DOI: 10.1143/JJAP.42.50
- HEIKMAN S ET AL: "Growth and characteristics of Fe-doped GaN", JOURNAL OF CRYSTAL GR, ELSEVIER, AMSTERDAM, NL, vol. 248, février 2003 (2003-02), pages 513-517, XP004399938, ISSN: 0022-0248, DOI: 10.1016/S0022-0248(02)01926-7
- OHBA Y ET AL: "A study on strong memory effects for Mg doping in GaN metalorganic chemical vapor deposition", JOURNAL OF CRYSTAL GROWTH, ELSEVIER, AMSTERDAM, NL, vol. 145, no. 1-4, 2 décembre 1994 (1994-12-02), pages 214-218, XP024461910, ISSN: 0022-0248, DOI: 10.1016/0022-0248(94)91053-7 [extrait le 1994-12-02]

## Description

L'invention concerne le procédé de fabrication des composants électroniques à hétéro jonction munis d'une couche barrière enterrée les séparant de leur substrat.

De nombreuses applications électroniques nécessitent dorénavant une amélioration de performances surtout dans l'électronique embarquée à destination de l'automobile et des transports terrestres, dans l'aéronautique, dans les systèmes médicaux ou dans des solutions domotiques par exemple. Ces applications nécessitent pour la plupart des commutateurs pour forte puissance fonctionnant dans des gammes de fréquences fréquemment supérieures au megahertz.

Une alternative pour des commutateurs de puissance, notamment à hautes fréquences, est l'utilisation de transistors à effet de champ à haute mobilité d'électrons, également désignés par le terme de transistor à effet de champ à hétérostructure. Un tel transistor inclut la superposition de deux couches semiconductrices ayant des bandes interdites différentes qui forment un puit quantique à leur interface. Des électrons sont confinés dans ce puits quantique pour former un gaz bidimensionnel d'électrons. Pour des raisons de tenue en haute tension et en température, ces transistors sont choisis de façon à présenter une large bande d'énergie interdite.

Parmi les transistors HEMT à large bande d'énergie interdite, les transistors à base de nitrure de gallium sont très prometteurs. Leur largeur de bande d'énergie interdite induit un champ électrique critique plus élevé comparé aux matériaux classiques de l'électronique, une vitesse de saturation élevée des porteurs et de bonnes stabilités thermique et chimique. Le champ de claquage du nitrure de gallium peut ainsi être supérieur à 2×10⁶ V/cm, ce qui permet aisément de réaliser des transistors compacts avec des tensions de claquage supérieures à 600 V. Avec un transistor à conduction latérale, la tension de claquage grille/drain peut aisément être contrôlée par une distance appropriée entre grille et drain. De plus, de tels transistors permettent de très grandes densités de courant du fait de la très grande mobilité électronique et de la forte densité électronique dans le gaz d'électrons d'interface.

Par ailleurs, d'autres composants à hétérojonction, tels que des diodes, font également l'objet d'importants développements.

Le document 'Characteristics of AlGaN/GaN/AlGaN double heterojunction HEMTs with an improved breakdown voltage' publié dans l'édition de janvier 2012, volume 33, numéro 1 de Journal of Semiconductors, décrit une première structure de transistor HEMT. Cette structure comprend un substrat en SiC, surmonté d'une couche de nucléation en AlN de 100 nm, surmontée d'une couche tampon en GaN de 1,5 µm, surmontée d'une couche intermédiaire en AlN de 1 nm, surmontée d'une couche en AlGaN de 22 nm, surmontée d'une couche de GaN de 1 nm, sur laquelle la source, la grille et le drain du transistor sont formés. Une couche de gaz d'électrons est formée à l'interface entre la couche tampon de GaN et la couche d'AlGaN, la couche intermédiaire en AlN étant considérée comme appartenant à cette interface.

En pratique, la couche tampon en GaN présente une barrière de potentiel relativement basse, de sorte que des électrons de la couche de gaz d'électrons peuvent facilement sortir du puits de potentiel pour être piégés dans la couche tampon en GaN, par exemple dans le cas où le transistor est bloqué. Les performances de conduction du transistor sont alors fortement dégradées car la densité en électrons est réduite.

Il a été proposé de former une couche barrière de type pGaN entre la couche tampon et le composant à hétérojonction, en incluant du magnésium dans la couche barrière à une proportion non négligeable afin de limiter la sortie des électrons hors du puits de potentiel, en élevant la bande de conduction. Le magnésium est typiquement choisi du fait de sa faible énergie d'ionisation parmi les dopants de type P. Une telle couche barrière de type pGaN est usuellement déposée par croissance épitaxiale en phase vapeur sur la couche tampon, en présence de magnésium dans le réacteur.

Cependant, on constate qu'une couche de GaN du composant, formée sur la couche barrière en pGaN, inclut une quantité non négligeable de magnésium, ce qui est généralement désigné par le terme d'effet mémoire du magnésium dans la littérature. Le profil de dopage en magnésium à l'interface entre la couche barrière en pGaN et la couche de GaN du composant à hétéro jonction décroît ainsi de façon lente en s'éloignant de la couche barrière. Pour diminuer la concentration en magnésium d'une décade dans la couche de GaN au-dessus de la couche barrière, une épaisseur de GaN de 100 nm s'avère nécessaire. Dans un tel cas de figure, la couche barrière remplit sa fonction de confinement de façon satisfaisante mais le magnésium présent dans la couche de GaN située au-dessus altère la mobilité dans la couche de gaz d'électrons du composant. La résistance de conduction du composant augmente alors significativement. Par ailleurs, le magnésium de cette couche de GaN peut piéger des électrons et augmenter la résistance du canal en fonctionement dynamique, ce qu'on appelle le « current collapse ».

Le document WO 2009/148930 A1 décrit un procédé de dépôt d'une couche de GaN incluant du Mg; le retrait d'une partie supérieur de la couche de GaN; et le dépôt d'une couche de matériau semiconducteur pour former une hétérojonction.

Le document intitulé 'Memory effect and redistribution of Mg into sequentially regrown GaN layer by Metalorganic Chemical Vapor Déposition', publié dans Japanese Journal of Applied Physics, en Janvier 2003 par Huili XING et al., décrit un procédé de dépôt d'une couche de pGaN incluant du Magnésium, suivi du maintien dans une atmosphère d'hydrogène, d'azote et d'ammoniac, sans Gallium, ce qui conduit à une gravure lente de la surface supérieure de la couche barrière et à un recuit de la couche de pGaN. Un tel procédé s'étant avéré inefficace pour obtenir une décroissance rapide de la concentration en magnésium dans la couche de GaN déposée ensuite sur la couche barrière. Le document propose en alternative de sortir le substrat muni de la couche barrière de l'enceinte de croissance épitaxiale, puis de mettre en œuvre une étape de gravure à l'acide de la partie supérieure de la couche barrière.

Un tel procédé pose d'importants problèmes d'industrialisation et peut conduire à une contamination de la surface supérieure de la couche barrière avant de nouvelles étapes de dépôt. Une telle contamination de la surface supérieure de la couche barrière, notamment par de l'oxygène, peut conduire à une forte altération des propriétés électriques du composant formé sur cette couche barrière.

On constate également que lors du démarrage de la croissance épitaxiale de la couche barrière, une épaisseur de dépôt de 100nm de pGaN s'avère nécessaire avant d'atteindre une concentration en Magnésium suffisante dans cette couche de pGaN.

L'invention vise à résoudre un ou plusieurs de ces inconvénients. L'invention porte ainsi sur un procédé de fabrication d'un composant électronique à hétérojonction muni d'une couche barrière enterrée, tel que défini dans les revendications annexées.

L'invention porte également sur les variantes des revendications dépendantes.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe schématique d'un composant électronique à hétérojonction muni d'une couche barrière enterrée de séparation avec son substrat ;
- la figure 2 est une vue en coupe schématique d'un exemple de transistor HEMT pouvant être formé sur une couche barrière ;
- les figures 3 à 7 sont des vues en coupe schématiques de différentes étapes d'un procédé de fabrication selon un premier mode de réalisation de l'invention ;
- la figure 8 est une vue en coupe schématique d'une étape de procédé de fabrication selon un deuxième mode de réalisation qui ne fait pas partie de l'invention ;
- la figure 9 est un diagramme comparatif de la concentration en Magnésium dans l'épaisseur d'un circuit intégré, en fonction de son procédé de fabrication ;
- la figure 10 est un diagramme comparatif de la concentration en Magnésium dans l'épaisseur d'une couche barrière, en fonction de variantes de procédés de fabrication selon un autre aspect de l'invention ;
- la figure 11 est une vue en coupe schématique d'un autre exemple de transistor HEMT pouvant être formé sur une couche barrière.

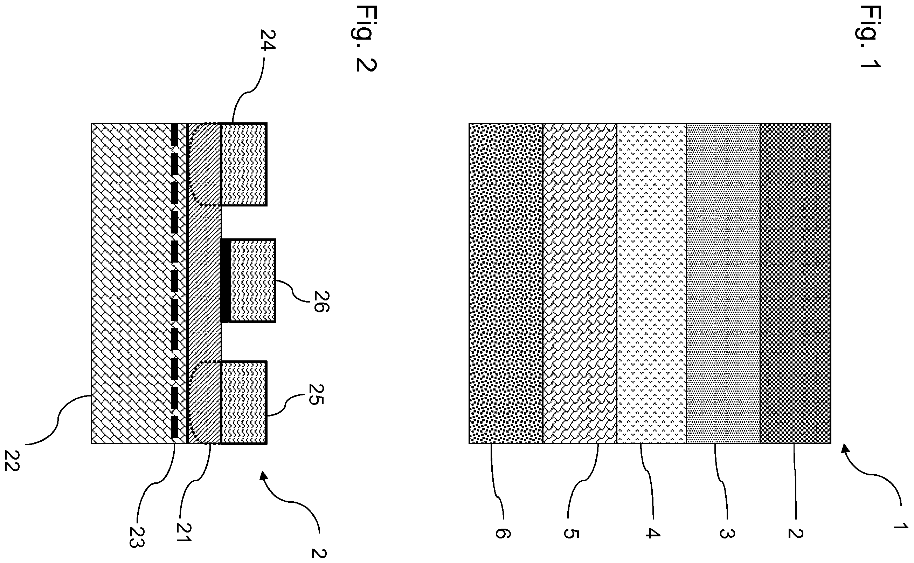

La figure 1 est une vue en coupe transversale schématique d'une structure multicouche 1, réalisé par un procédé de fabrication selon l'invention. La structure multicouche 1 comprend un composant électronique 2 à hétérojonction, formé sur une couche barrière 3. La couche barrière 3 est ici formée sur une couche 4 de matériau semi-conducteur en GaN. La couche 4 est formée sur une couche tampon 5, elle-même fixée sur un substrat 6.

Le composant électronique 2 à hétérojonction à haute mobilité électronique peut par exemple être un transistor de type HEMT (normalement passant ou normalement ouvert) ou une diode à hétérojonction.

Le substrat 6 présente une structure connue en soi. Le substrat 6 peut être un isolant ou un semi-conducteur de type silicium intrinsèque ou dopé, ou du SiC du saphir ou même de l'AlN. Le substrat 6 peut typiquement présenter une épaisseur de l'ordre de 350 µm à 1,5mm.

Une couche d'adaptation non illustrée peut être interposée entre le substrat 6 et la couche tampon 5. La couche tampon 5 est par exemple en GaN dopé Carbone ou inclut des couches AlₓGa₍₁₋ₓ₎N ou d'autres couches de nitrure. La couche de GaN 4 est par exemple formée en GaN de type non intentionnellement dopé, ou dopé carbone, ou également une couche AlₓGa₍₁₋ₓ₎N. La couche barrière 3 comprend au moins une couche de GaN à dopage de type P, le dopant de type P étant du Magnésium.

La figure 2 est une vue en coupe schématique d'un exemple de composant électronique 2, de type transistor à haute mobilité électronique de type normalement passant, qui veut dire que sans appliquer une tension sur la grille, le canal est passant. Le transistor 2 comprend ici une couche de GaN non intentionnellement dopée 22 disposée sur la couche barrière 3. Le transistor 1 comprend ici en outre une couche d'AlGaN (ou InAlN ou InGaAlN ou AlN, avec une bande interdite supérieur à celle du GaN) 21 disposée sur la couche 22. Un gaz d'électrons est intrinsèquement formé par hétérojonction à l'interface entre la couche 21 et la couche 22, dans la couche 22. Dans un souci de lisibilité, le gaz d'électrons est illustré sous forme d'une couche 23.

Une couche intermédiaire non illustrée peut être interposée de façon connue en soi entre les couches 21 et 22, par exemple pour accroître la densité d'électrons et la mobilité dans le gaz d'électrons. Une telle couche intermédiaire est typiquement extrêmement fine (par exemple 1nm) est peut être réalisée en AlN (particulièrement adapté à l'interface entre une couche 22 en GaN et une couche 21 en AlGaN).

De façon connue en soi, le transistor 2 est ici du type à conduction latérale et comporte une source 24, un drain 25 et une grille de commande 26 formés de façon connue en soi sur la couche d'AlGaN 21. La grille de commande 26 est positionnée entre la source 24 et le drain 25. La source 24 et le drain 25 sont connectés électriquement à la couche de gaz d'électrons 23. La source 24, le drain 25 et la grille de commande 26 sont illustrés uniquement schématiquement, leurs dimensions et leurs structures pouvant différer fortement de l'illustration de la figure 2.

La couche barrière 3 pourrait être en pGaN, dopé par magnésium. Dans ce cas, la partie inférieure de la couche de GaN non-intentionnellement dopé 22 a tendance à inclure du magnésium provenant du processus d'épitaxie de la couche barrière 3. L'influence de ce magnésium sur la mobilité électronique de la couche de gaz d'électrons 23 doit être limitée autant que possible, si possible en évitant d'accroître l'épaisseur de la couche de GaN 22. L'épaisseur de la couche de GaN 22 est à minimiser notamment pour favoriser la performance des transistors de type normalement bloqué.

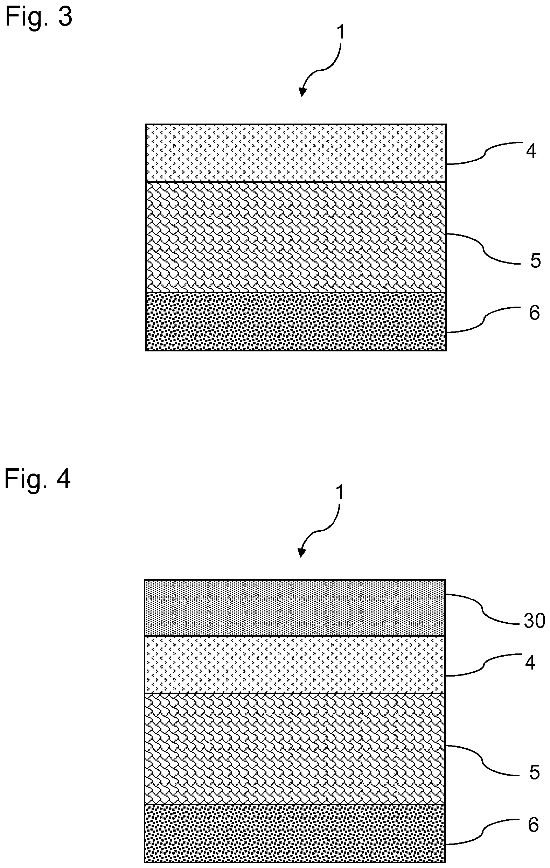

Les figures 3 à 7 sont des vues en coupe schématiques illustrant différentes étapes d'un procédé de fabrication selon un premier mode de réalisation de l'invention.

À la figure 3, on fournit une structure multicouche 1 en formation, muni d'un substrat 6 surmonté d'une couche tampon 5 et d'une couche de GaN 4, tels que décrits précédemment et pouvant être obtenus par des procédés connus en soi.

À la figure 4, on procède au dépôt d'une couche de pGaN 30, selon des paramètres connus en soi. Par exemple, en plaçant la structure 1 dans une enceinte de croissance épitaxiale en phase vapeur (non illustrée), on crée une atmosphère gazeuse dans l'enceinte, avec un mélange incluant des précurseurs du Gallium (par exemple TMGa), du Magnésium (par ex Cp₂Mg), de l'ammoniac, de l'hydrogène et de l'azote. La pression partielle d'ammoniac dans le mélange est typiquement comprise entre 4000 et 6000 Pa pour cette étape. La concentration d'un gaz dans l'atmosphère à l'intérieur de l'enceinte pourra être exprimée comme le rapport de la pression partielle de ce gaz sur la pression totale dans l'enceinte. La pression partielle de magnésium est fixée à un niveau permettant d'obtenir la concentration souhaitée en magnésium pour la couche barrière. On peut par exemple viser une concentration moyenne en magnésium au moins égale à de 1 * 10¹⁷ cm⁻³, voire au moins égale à de 1 * 10¹⁸ cm⁻³ dans la couche barrière 3. La température dans l'enceinte pour réaliser la croissance épitaxiale de la couche 30 est par exemple de 1050° C. Le dépôt de la couche de pGaN 30 peut avantageusement être réalisé sur une épaisseur comprise entre 90 et 250 nm.

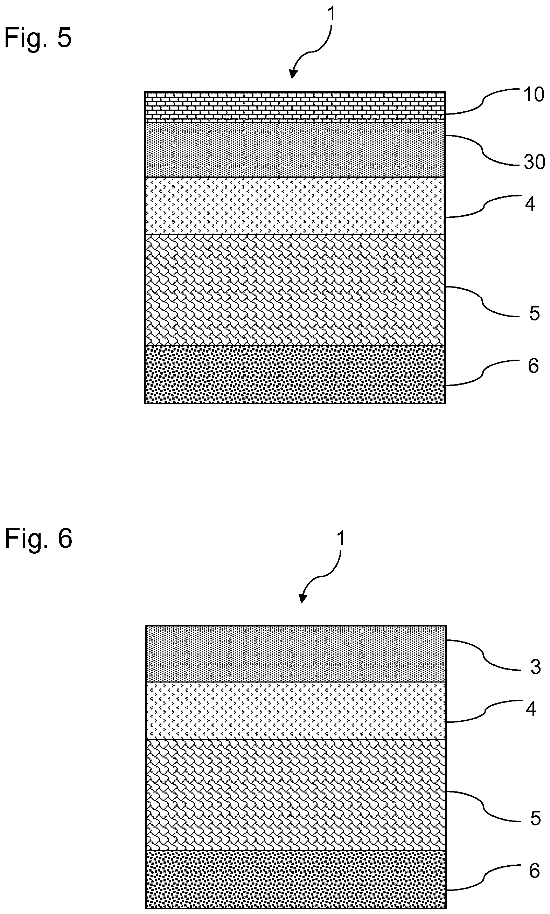

La figure 5 illustre une autre étape du procédé de fabrication selon le premier mode de réalisation. En maintenant la structure 1 dans l'enceinte de croissance épitaxiale en phase vapeur, on modifie l'atmosphère gazeuse dans l'enceinte en supprimant l'alimentation en magnésium de l'atmosphère de l'enceinte. L'enceinte est ainsi maintenue dans une atmosphère gazeuse de croissance épitaxiale avec un mélange incluant du Gallium, de l'ammoniac, du dihydrogène et de l'azote. On procède ainsi au dépôt d'une couche 10 de GaN sur la couche 30 de pGaN, avec des conditions de formation d'une couche de type non intentionnellement dopé. La combinaison de la couche de pGaN 30 et de la couche de GaN 10 forme une couche précurseur de la couche barrière en cours de fabrication.

La pression partielle d'ammoniac dans le mélange pour le dépôt de la couche 10 est typiquement comprise entre 4000 et 6000 Pa pour cette étape. La température dans l'enceinte pour réaliser la croissance épitaxiale de la couche 10 est par exemple de 1050° C. Le dépôt de la couche de pGaN 10 peut avantageusement être réalisé sur une épaisseur comprise entre 50 et 120 nm. Du fait de l'effet mémoire du magnésium utilisé lors du dépôt de la couche 30, la couche 10 inclut également du magnésium. La concentration en magnésium décroît dans la couche 10 au fur et à mesure qu'on s'éloigne de son interface avec la couche 30.

Pour obtenir la configuration illustrée à la figure 6, on a maintenu la structure multicouches 1 dans l'enceinte de croissance épitaxiale. On place alors l'atmosphère à l'intérieur de l'enceinte dans des conditions de retrait intégral de la couche 10 et de la partie supérieure de la couche 30. L'atmosphère à l'intérieur de l'enceinte pour cette étape de retrait présente ici une concentration Cg1 en ammoniac, au plus égale au tiers de la concentration Cd1 en ammoniac de l'atmosphère durant le dépôt de la couche 30. Avantageusement, la concentration Cg1 est au plus égale à 10 % de la concentration Cd1. L'étape de retrait comprend ici le retrait de l'intégralité de la couche 10. Le retrait est réalisé par un mécanisme de désorption de la couche 10.

Avantageusement, la concentration en ammoniac Cg1 dans l'atmosphère durant cette étape de retrait est non nulle, afin de stabiliser le processus de gravure/retrait. La concentration en ammoniac Cg1 dans l'atmosphère à l'intérieur de l'enceinte pour cette étape de retrait peut par exemple être au moins égale à 4 % de la concentration Cd1, et peut par exemple être égale à 5% de la concentration Cd1.

Le retrait de la partie supérieure de la couche précurseur est avantageusement mis en œuvre sur une épaisseur au moins égale à 20 nm, afin de favoriser le front de décroissance de la concentration en magnésium.

L'atmosphère utilisée pour mettre en œuvre cette étape de retrait comprend du dihydrogène et ce retrait est mis en œuvre à une température de 1050°C. Avec de telles conditions de retrait, une vitesse de gravure de 12 µm/h a été obtenue pour la couche 10 avec une concentration en ammoniac Cg1 nulle, et une vitesse de gravure de 2 µm/h a été obtenue pour la couche 10 avec une pression partielle d'ammoniac comprise entre 200 et 300 Pa.

Comme illustré à la figure 6, on a alors retrouvé la couche barrière enterrée 3.

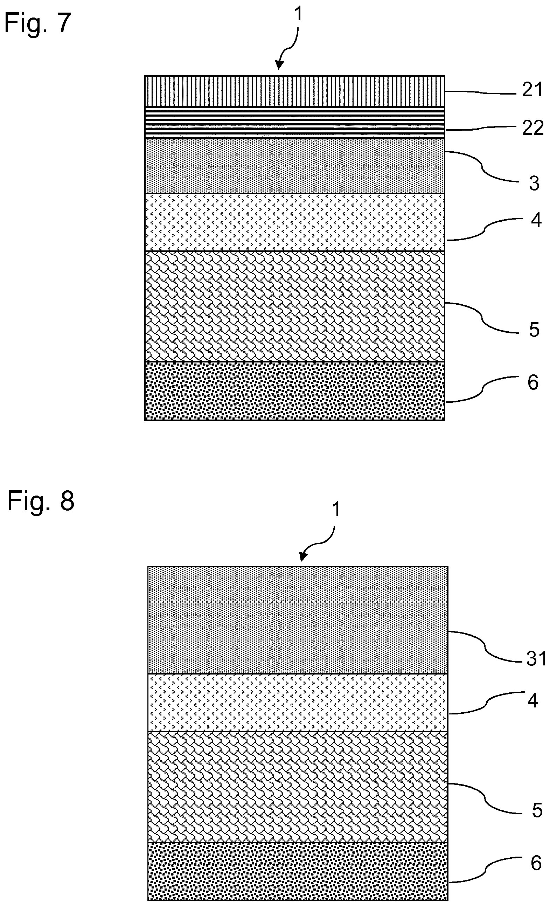

À la figure 7, on a procédé à un dépôt d'une couche de matériau semi-conducteur du composant à former, sur la couche barrière 3. Dans l'exemple illustré, on a procédé à un dépôt par épitaxie d'une couche 22 de GaN de type non intentionnellement dopé sur la couche barrière 3. On a ensuite procédé à un dépôt par épitaxie d'une couche 21 en AlGaN sur la couche 22, de façon à former une couche de gaz électrons à leur interface. Des étapes additionnelles d'un procédé de fabrication du transistor 2 à partir des couches 21 et 22 ne seront pas davantage détaillées (formation d'une source, d'un drain et d'une grille du transistor 2 par exemple), ces étapes étant connues en soi de l'homme du métier.

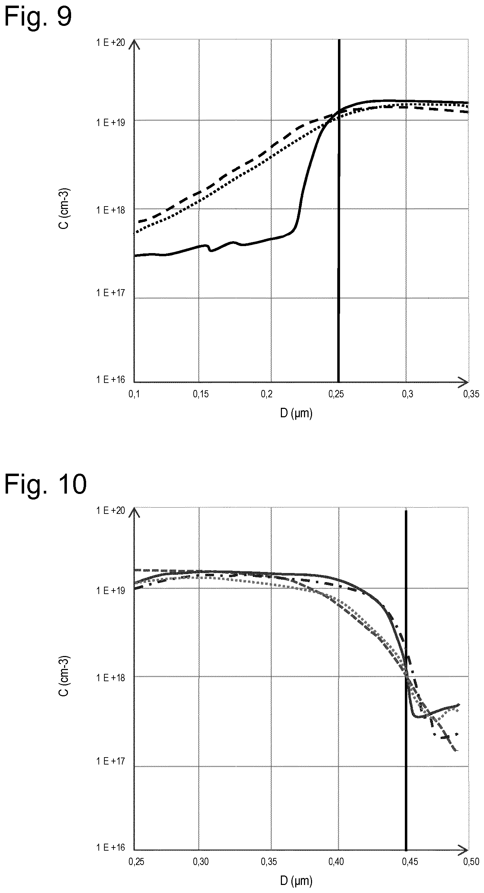

La figure 9 est un diagramme comparatif de la concentration C en Magnésium en fonction de la position D dans la profondeur d'une structure multicouche, et en fonction de son procédé de fabrication. Une profondeur D nulle correspond à la face supérieure de la couche 21 du transistor 2 à hétéro jonction. Une profondeur de 0,25µm correspond à l'interface entre la couche barrière 3 et la couche de GaN 22. La courbe en trait discontinu correspond à une structure réalisée selon un procédé de l'état de la technique, dans lequel la couche de GaN 22 est déposée par épitaxie immédiatement après le dépôt par épitaxie de la couche de pGaN de la couche barrière 3. La courbe en pointillés correspond à un circuit intégré réalisé selon un procédé de l'état de la technique, dans lequel un recuit de 5 minutes est mis en œuvre entre le dépôt de la couche barrière 3 et le dépôt de la couche de GaN 22, en retirant le gallium (TMGa) de l'atmosphère de l'enceinte pendant ce recuit. La courbe en trait continu correspond à une structure 1 obtenue avec un procédé de fabrication selon le premier mode de réalisation.

On constate d'une part qu'une épaisseur de GaN d'au moins 100 nm s'avère nécessaire pour un procédé selon l'état de la technique, pour réduire la concentration en Magnésium d'une décade par rapport à son interface avec la couche barrière 3. Même avec un procédé selon l'état de la technique mettant en œuvre une étape de recuit, une telle épaisseur de GaN s'avère nécessaire pour réduire la concentration en magnésium d'une décade par rapport à l'interface avec la couche barrière 3.

A contrario, on constate que la concentration en magnésium baisse d'une décade avec une épaisseur de GaN d'environ 30 nm pour un une structure 1 réaliser selon le premier mode de réalisation.

Le procédé de fabrication selon l'invention permet ainsi d'accroître la pente de décroissance de la concentration en magnésium dans la couche de matériau semi-conducteur formée sur la couche barrière 3. Selon l'invention, la pente de décroissance de la concentration en magnésium dans la couche de matériau semi-conducteur formé sur la couche barrière 3 est donc particulièrement abrupte. La mobilité électronique dans la couche de gaz d'électrons du composant 2 formé sur la couche barrière 3 est ainsi fortement améliorée, et ce même avec une couche 22 relativement fine. Avec une couche barrière 3 présentant un front très abrupt de concentration en magnésium, on peut limiter au maximum l'épaisseur de cette couche barrière 3, tout en conservant une fonction de barrière de potentiel particulièrement efficace.

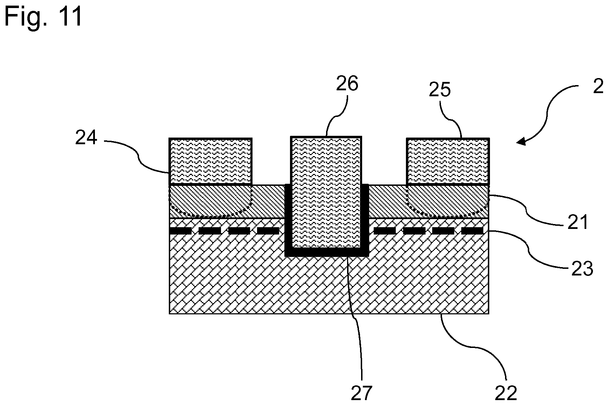

Ceci peut s'avérer particulièrement avantageux pour un transistor de type normalement bloqué (tel qu'illustré schématiquement à la figure 11) avec une grille formée dans un retrait 27 traversant la couche d'AlGaN 21 et s'étendant jusque dans la couche de GaN 22. En effet, on peut alors envisager de réduire l'épaisseur de la couche de GaN 22 dans laquelle la conduction s'effectue par inversion et non par l'intermédiaire de la couche de gaz d'électrons. Il est intéressant de réduire l'épaisseur de la couche 22 pour éviter des résistances élevées sur les coté de la grille entre le gaz bi-dimensionnel et la couche d'inversion sous la grille.

Dans un exemple qui ne fait pas partie de l'invention, afin d'accroître encore la vitesse de décroissance de la concentration en magnésium au-dessus de la couche barrière 3, et afin de mieux contrôler l'épaisseur retirée de la couche 10, le procédé met avantageusement en œuvre une alternance d'étapes de :
- retrait partiel de la couche 10 ;
- croissance par épitaxie d'une couche de GaN avec des conditions de formation d'une couche de type non intentionnellement dopé.

On peut par exemple envisager de mettre en œuvre au moins une dizaine d'alternances de telles étapes.

L'étape de retrait est ici avantageusement mise en œuvre en maintenant une certaine concentration en ammoniac dans l'atmosphère de l'enceinte. Un tel retrait permet à la fois d'obtenir une vitesse de retrait suffisamment élevée pour mettre en œuvre un processus industriel rapidement, et suffisamment faible pour bien contrôler le processus de retrait. Par ailleurs, un tel retrait peut être réalisé dans les mêmes conditions de température que le dépôt de la couche 30, ce qui permet d'éviter de nécessiter un refroidissement préalable de la structure.

Dans un exemple qui ne fait pas partie de l'invention, on peut cependant également envisager de mettre en œuvre un retrait avec d'autre atmosphère dans l'enceinte, à l'issue du dépôt par épitaxie de la couche précurseur de la couche barrière 3. On peut par exemple introduire du Cl₂ ou du HCl dans l'enceinte pour mettre en œuvre l'étape de retrait.

Un deuxième mode de réalisation qui ne fait pas partie de l'invention peut également être mis en œuvre. Le deuxième mode de réalisation peut mettre en œuvre les étapes préalables de procédé décrites en référence à la figure 3.

À la figure 8, on procède au dépôt d'une couche de pGaN 31, selon des paramètres connus en soi. La couche de pGaN 31 forme ici la couche précurseur de la couche barrière 3. La couche 31 est ici plus épaisse que la couche 30 du premier mode de réalisation. La couche 31 comporte une partie sacrificielle.

Le dépôt par épitaxie de la couche 31 est réalisé par exemple en plaçant la structure multicouche―1 dans l'enceinte de croissance épitaxiale en phase vapeur, en créant une atmosphère gazeuse dans l'enceinte, avec un mélange incluant du Gallium, du Magnésium, de l'ammoniac, du dihydrogène et de l'azote. La pression partielle d'ammoniac dans le mélange est typiquement comprise entre 4000 et 6000 Pa pour cette étape. La température dans l'enceinte pour réaliser la croissance épitaxiale de la couche 31 est par exemple de 1050° C. Le dépôt de la couche de pGaN 31 peut avantageusement être réalisé sur une épaisseur comprise entre 190 et 350 nm.

Le procédé tel que décrit en référence aux figures 6 et 7 du premier mode de réalisation peut ensuite entre repris, en effectuant le retrait de la partie supérieure de la couche 31 au lieu du retrait de la couche 10. On maintient ainsi le la structure multicouches 1 dans l'enceinte de croissance épitaxiale. On place l'atmosphère à l'intérieur de l'enceinte dans des conditions de retrait de la couche 31. L'atmosphère à l'intérieur de l'enceinte pour cette étape de retrait présente ici une concentration Cg1 en ammoniac, au plus égale au tiers de la concentration Cd1 en ammoniac de l'atmosphère durant le dépôt de la couche 31. Avantageusement, la concentration Cg1 est au plus égale à 10 % de la concentration Cd1. L'étape de retrait comprend ici le retrait d'une épaisseur de 100nm de la couche 31. Le retrait est réalisé par un mécanisme de désorption de la partie supérieure de la couche 31.

Selon un autre aspect indépendant de l'invention, l'étape de formation de la couche précurseur de la couche barrière 3 peut être mise en œuvre de façon à ce que la concentration en magnésium dans le fond de cette couche barrière 3 soit très abrupte. Avec un tel front abrupt, on peut utiliser une barrière 3 encore moins épaisse.

À cet effet, l'étape de dépôt de la couche précurseur en pGaN détaillée en référence à la figure 4 peut être mise en œuvre de la façon suivante. Lorsque la structure multicouches 1 est disposée dans l'enceinte de croissance épitaxiale en phase vapeur, la surface de la couche est saturée préalablement en magnésium, avant que les conditions de croissance par épitaxie de la couche précurseur en pGaN ne soient établies. L'ajout du précurseur du magnésium dans l'enceinte pour atteindre la saturation en magnésium de la surface peut avantageusement être réalisé pendant une durée au moins égale à 10 secondes. Une fois la surface saturée en magnésium, on initie le dépôt de la couche de pGaN avec des conditions de croissance par épitaxie tel que décrit en référence à la figure 4. La saturation est faite par l'envoi du précurseur de magnésium sans envoyer le précurseur du gallium, ou avec très peu du précurseur du gallium.

La figure 10 illustre un diagramme comparatif de la concentration en magnésium dans l'épaisseur de la couche barrière 3 en fonction de la durée de maintien de l'atmosphère en magnésium, préalablement au dépôt par épitaxie de la couche pGaN. Le trait vertical correspond au fond de la couche barrière 3. La courbe en trait discontinu correspond à un procédé de fabrication dépourvu de maintien de l'atmosphère de l'enceinte d'épitaxie avec du magnésium avant le dépôt par épitaxie de la couche pGaN. La courbe en pointillés correspond à un procédé de fabrication dans lequel l'atmosphère de l'enceinte d'épitaxie est maintenue avec du magnésium pendant une durée de 30 secondes avant le dépôt par épitaxie de la couche pGaN. La courbe en tiret-point correspond à un procédé de fabrication dans lequel l'atmosphère de l'enceinte d'épitaxie est maintenue avec du magnésium pendant une durée de 90 secondes avant le dépôt par épitaxie de la couche pGaN. La courbe en trait continu correspond à un procédé de fabrication dans lequel l'atmosphère de l'enceinte d'épitaxie est maintenue avec une du magnésium pendant une durée de 120 secondes avant le dépôt par épitaxie de la couche pGaN. On constate que plus on maintient longtemps l'atmosphère avec du Magnésium avant de rentrer dans les conditions d'épitaxie, plus le front de concentration en Magnésium au fond de la couche barrière 3 est abrupt.

Les exemples ont été décrits dans une application à l'inclusion d'un dopant de type Mg dans la couche barrière enterrée. Une problématique identique est rencontrée avec la croissance de GaN dopé en Fe, qui est utilisé pour rendre isolant les couches GaN pour les applications de transistors à très haute fréquence. Pour l'ensemble des étapes détaillées précédemment, le Mg peut être remplacé par le Fe dans le cadre de l'invention pour mieux maîtriser la croissance de ces couches dopées.

## Revendications

1. Procédé de fabrication d'un composant électronique à hétérojonction (2) muni d'une couche barrière enterrée (3), comprenant les étapes de :
- sur un substrat (6) disposé dans une enceinte de croissance épitaxiale en phase vapeur, avec une atmosphère dans l'enceinte présentant une première concentration non nulle en ammoniac, dépôt par épitaxie d'une couche (30) de GaN précurseur de la couche barrière enterrée, cette couche précurseur (30) comprenant une première couche dopée avec un dopant étant du Mg ou du Fe, le dépôt par épitaxie de la couche de GaN précurseur comprenant un dépôt par épitaxie, sur la première couche (30) dopée avec ledit dopant, d'une deuxième couche (10) de GaN dans une atmosphère dans l'enceinte non alimentée en ledit dopant ;
- en maintenant le substrat dans l'enceinte de croissance épitaxiale, placement de l'atmosphère à l'intérieur de l'enceinte avec une deuxième concentration en ammoniac au plus égale au tiers de la première concentration de façon à retirer une partie supérieure de la couche précurseur (30), le retrait de la partie supérieure de la couche précurseur comprenant le retrait intégral de la deuxième couche (10) de GaN ; puis
- après le retrait de ladite partie supérieure de la couche précurseur, en maintenant le substrat dans l'enceinte de croissance épitaxiale, dépôt par épitaxie, sur ladite couche précurseur, d'une couche de matériau semi-conducteur (22) du composant électronique à hétérojonction à fabriquer, ladite couche précurseur formant alors la couche barrière enterrée (3) sous ladite couche de matériau semi-conducteur (22).

2. Procédé de fabrication d'un composant électronique à hétérojonction (2) selon la revendication 1, dans lequel une pression partielle d'ammoniac au moins égale à 200Pa est maintenue dans l'enceinte pendant le retrait de la partie supérieure de la couche précurseur.

3. Procédé de fabrication d'un composant électronique à hétérojonction (2) selon la revendication 1 ou 2, dans lequel ledit retrait est effectué avec une atmosphère dans l'enceinte comprenant du dihydrogène.

4. Procédé de fabrication d'un composant électronique à hétérojonction (2) selon l'une quelconque des revendications précédentes, dans lequel ledit retrait est effectué avec une atmosphère dans l'enceinte qui contient du Cl₂ ou du HCl.

5. Procédé de fabrication d'un composant électronique à hétérojonction (2) selon l'une quelconque des revendications précédentes, comprenant la répétition de ladite étape de retrait de la partie supérieure de la couche précurseur, le procédé comprenant en outre, entre deux desdites étapes de retrait répétées, une étape de croissance par épitaxie d'une couche de GaN sur ladite couche précurseur, dans une atmosphère dans l'enceinte non alimentée en ledit dopant.

6. Procédé de fabrication d'un composant électronique à hétérojonction (2) selon l'une quelconque des revendications précédentes, dans lequel ladite étape de dépôt par épitaxie de la couche précurseur est précédée par une étape de saturation de la surface de la couche en ledit dopant.

7. Procédé de fabrication d'un composant électronique à hétéro jonction (2) selon l'une quelconque des revendications précédentes, dans lequel ladite étape de retrait retire une épaisseur d'au moins 20 nm de ladite couche précurseur.

## Patentansprüche

1. Verfahren zur Herstellung einer elektronischen Komponente mit Heteroübergang (2), die mit einer vergrabenen Barriereschicht (3) ausgestattet ist, umfassend die folgenden Schritte:
- auf ein Substrat (6), das in einer Gasphasenepitaxie-Wachstumskammer angeordnet ist, mit einer Atmosphäre in der Kammer, die eine erste Ammoniakkonzentration ungleich null aufweist, epitaktisches Abscheiden einer GaN-Vorläuferschicht (30) der vergrabenen Barriereschicht, wobei diese Vorläuferschicht (30) eine erste Schicht umfasst, die mit einem Dotierungsmittel dotiert ist, das Mg oder Fe ist, wobei das epitaktische Abscheiden der GaN-Vorläuferschicht ein epitaktisches Abscheiden, auf der mit dem Dotierungsmittel dotierten ersten Schicht (30), einer zweiten GaN-Schicht (10) in einer Atmosphäre in der Kammer, der das Dotierungsmittel nicht zugeführt wird, umfasst;
- unter Beibehaltung des Substrats in der Epitaxie-Wachstumskammer, Versehen der Atmosphäre in der Kammer mit einer zweiten Ammoniakkonzentration, die höchstens ein Drittel der ersten Konzentration beträgt, so dass ein oberer Teil der Vorläuferschicht (30) entfernt wird, wobei das Entfernen des oberen Teils der Vorläuferschicht das vollständige Entfernen der zweiten GaN-Schicht (10) umfasst; dann
- nach dem Entfernen des oberen Teils der Vorläuferschicht, unter Beibehaltung des Substrats in der Epitaxie-Wachstumskammer, epitaktisches Abscheiden, auf der Vorläuferschicht, einer Halbleitermaterialschicht (22) der herzustellenden elektronischen Komponente mit Heteroübergang, wobei die Vorläuferschicht dann die vergrabene Barriereschicht (3) unter der Halbleitermaterialschicht (22) bildet.

2. Verfahren zur Herstellung einer elektronischen Komponente mit Heteroübergang (2) nach Anspruch 1, wobei ein Ammoniakteildruck von mindestens 200 Pa in der Kammer während des Entfernens des oberen Teils der Vorläuferschicht beibehalten wird.

3. Verfahren zur Herstellung einer elektronischen Komponente mit Heteroübergang (2) nach Anspruch 1 oder 2, wobei das Entfernen bei einer Atmosphäre in der Kammer durchgeführt wird, die Diwasserstoff umfasst.

4. Verfahren zur Herstellung einer elektronischen Komponente mit Heteroübergang (2) nach einem der vorhergehenden Ansprüche, wobei das Entfernen bei einer Atmosphäre in der Kammer durchgeführt wird, die Cl₂ oder HCl enthält.

5. Verfahren zur Herstellung einer elektronischen Komponente mit Heteroübergang (2) nach einem der vorhergehenden Ansprüche, umfassend die Wiederholung des Schritts des Entfernens des oberen Teils der Vorläuferschicht, wobei das Verfahren ferner, zwischen den beiden wiederholten Schritten des Entfernens, einen Schritt des epitaktischen Aufwachsens einer GaN-Schicht auf der Vorläuferschicht in einer Atmosphäre in der Kammer, welcher das Dotierungsmittel nicht zugeführt wird, umfasst.

6. Verfahren zur Herstellung einer elektronischen Komponente mit Heteroübergang (2) nach einem der vorhergehenden Ansprüche, wobei dem Schritt des epitaktischen Abscheidens der Vorläuferschicht ein Schritt des Sättigens der Oberfläche der Schicht mit dem Dotierungsmittel vorausgeht.

7. Verfahren zur Herstellung einer elektronischen Komponente mit Heteroübergang (2) nach einem der vorhergehenden Ansprüche, bei dem der Schritt des Entfernens eine Dicke von mindestens 20 nm der Vorläuferschicht entfernt.

## Claims

1. Method for the manufacture of a heterojunction electronic component (2) provided with an embedded barrier layer (3), comprising the stages of:
- deposition by epitaxy, on a substrate (6) positioned in a vapour phase epitaxial growth chamber, with an atmosphere in the chamber exhibiting a first nonzero ammonia concentration, of a GaN precursor layer (30) of the embedded barrier layer, this precursor layer (30) comprising a first layer doped with a dopant which is Mg or Fe, the deposition by epitaxy of the GaN precursor layer comprising a deposition by epitaxy, on the first layer (30) doped with the said dopant, of a GaN second layer (10) in an atmosphere in the chamber not fed with the said dopant;
- while maintaining the substrate in the epitaxial growth chamber, placing the atmosphere inside the chamber with a second ammonia concentration at most equal to a third of the first concentration, so as to remove an upper part of the precursor layer (30), the removal of the upper part of the precursor layer comprising the complete removal of the GaN second layer (10); then
- after the removal of the said upper part of the precursor layer, while maintaining the substrate in the epitaxial growth chamber, deposition by epitaxy, on the said precursor layer, of a layer of semiconductor material (22) of the heterojunction electronic component to be manufactured, the said precursor layer then forming the embedded barrier layer (3) under the said layer of semiconductor material (22).

2. Method for the manufacture of a heterojunction electronic component (2) according to Claim 1, in which an ammonia partial pressure at least equal to 200 Pa is maintained in the chamber during the removal of the upper part of the precursor layer.

3. Method for the manufacture of a heterojunction electronic component (2) according to Claim 1 or 2, in which the said removal is carried out with an atmosphere in the chamber comprising molecular hydrogen.

4. Method for the manufacture of a heterojunction electronic component (2) according to any one of the preceding claims, in which the said removal is carried out with an atmosphere in the chamber which contains Cl₂ or HCl.

5. Method for the manufacture of a heterojunction electronic component (2) according to any one of the preceding claims, comprising the repetition of the said stage of removal of the upper part of the precursor layer, the method additionally comprising, between two of the said repeated removal stages, a stage of growth by epitaxy of a GaN layer on the said precursor layer, in an atmosphere in the chamber not fed with the said dopant.

6. Method for the manufacture of a heterojunction electronic component (2) according to any one of the preceding claims, in which the said stage of deposition by epitaxy of the precursor layer is preceded by a stage of saturation of the surface of the layer with the said dopant.

7. Method for the manufacture of a heterojunction electronic component (2) according to any one of the preceding claims, in which the said stage of removal removes a thickness of at least 20 nm from the said precursor layer.
